(19)

(11) EP 2 867 693 B1

(12) EUROPÄISCHE PATENTSCHRIFT

(45) Veröffentlichungstag und Bekanntmachung des Hinweises auf die Patenterteilung: **05.06.2019 Patentblatt 2019/23**

(21) Anmeldenummer: **13730591.8**

(22) Anmeldetag: **24.06.2013**

(51) Int Cl.:
***G01S 17/88*** *(2006.01)* ***G01S 7/486*** *(2006.01)*
***H03M 1/12*** *(2006.01)*

(86) Internationale Anmeldenummer:
**PCT/EP2013/063144**

(87) Internationale Veröffentlichungsnummer:
**WO 2014/001258 (03.01.2014 Gazette 2014/01)**

(54) **DISTANZMESSVERFAHREN UND DISTANZMESSER**

DISTANCE MEASURING METHOD AND DISTANCE METER

PROCÉDÉ DE MESURE DE DISTANCE ET DISPOSITIF DE MESURE DE DISTANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.06.2012 EP 12173909**

(43) Veröffentlichungstag der Anmeldung:
**06.05.2015 Patentblatt 2015/19**

(73) Patentinhaber: **Leica Geosystems AG**
**9435 Heerbrugg (CH)**

(72) Erfinder: **STUTZ, Reto**
**9442 Berneck (CH)**

(74) Vertreter: **Kaminski Harmann**
**Patentanwälte AG**
**Landstrasse 124**
**9490 Vaduz (LI)**

(56) Entgegenhaltungen:
**EP-A1- 1 882 959** **EP-A2- 0 875 772**
**WO-A2-03/089950**

EP 2 867 693 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die Erfindung betrifft ein Distanzmessverfahren nach Anspruch 1 sowie einen Distanzmesser nach Anspruch 10. Im Bereich der elektronischen bzw. elektrooptischen Distanzmessung sind verschiedene Prinzipien und Verfahren bekannt. Ein Ansatz besteht darin, gepulste elektromagnetische Strahlung, wie z.B. Laserlicht, auf ein zu vermessendes Ziel auszusenden und nachfolgend ein Echo von diesem Ziel als rückstreuendes Objekt zu empfangen, wobei die Distanz zum zu vermessenden Ziel anhand der Laufzeit des Pulses bestimmt wird. Solche Pulslaufzeitmesser haben sich mittlerweile in vielen Bereichen als Standardlösungen durchgesetzt. Zur Detektion des zurückgestreuten Pulses werden unterschiedliche Ansätze verwendet.

Bei der sogenannten Schwellwertmethode wird ein Lichtpuls detektiert, wenn die Intensität der einfallenden Strahlung einen gewissen Schwellwert überschreitet.

Ein anderer Ansatz basiert auf der Abtastung bzw. dem Sampling des rückgestreuten Pulses. Ein emittiertes Signal wird detektiert, indem die von einem Detektor erfasste Strahlung abgetastet, innerhalb des abgetasteten Bereichs ein Signal identifiziert und schliesslich dessen Lage bestimmt wird. Durch die Verwendung einer Vielzahl von Abtastwerten kann ein Nutzsignal auch unter ungünstigen Umständen identifiziert werden, so dass auch grössere Distanzen oder verrauschte bzw. mit Störungen behaftete Hintergrundszenarien bewältigt werden können. Im Stand der Technik erfolgt ein Sampling durch Abtastung vieler identischer Pulse mit Verschiebung des Zeitfensters bzw. der Phase, wobei derzeit sehr schnelle Schaltungen realisiert werden können, die hochfrequent genug sind, um einzelne Pulse abzutasten.

Problematisch sind jedoch die Anforderungen an die Signalabtastung und die Voraussetzungen für eine Signalrekonstruktion, insbesondere bei der Verwendung von veränderlichen oder verzerrten Signalen. Aufgrund der technisch nach oben begrenzten Abtastraten können nicht alle Signalanteile in gleicher Weise abgetastet werden. Wird das sog. Nyquist-Abtasttheorem nicht beachtet, so können sogenannte Aliasing-Effekte auftreten, welche die Signalrekonstruktion verfälschen und somit die Messgenauigkeit verringern. Im Stand der Technik sind hierbei Lösungen bekannt, welche dennoch eine geringfügige Verletzung der Nyquist-Bedingung hinnehmen oder aber die höherfrequenten Signalanteile durch Filterung soweit reduzieren, dass die Nyquist-Bedingung für das gefilterte Signal erfüllbar ist.

So wird in der WO 2011/076907 eine Vorrichtung zur hochgenauen Distanzmessung nach dem Prinzip der direkten Abtastung des reflektierten Signals geoffenbart, bei der das Empfangssignal mit einer Samplingschaltung abgetastet und anschliessend quantisiert wird. Dem Empfangssignalpfad ist vor der Abtastung ein Filter hoher Ordnung zugeteilt. Dieses Filter hat typischerweise die Ordnung 6 oder höher und ist nicht wie bei den anderen Vorrichtungen nach dem Stand der Technik als ein einfaches Antialiasing-Filter 1., 2. oder höchstens 3. Ordnung ausgelegt. Bei einem solchen Distanzmessverfahren ist eine vollständige Identifikation der Kurvenform nicht mehr zwingend erforderlich. Da vor dem Abtasten die Signalbandbreite so reduziert wird, dass alle für die distanzrelevanten Frequenzen unterhalb der halben Samplingfrequenz liegen, kann nach dem Nyquist-Theorem das dann verbleibende und für den beabsichtigten Messzweck ausreichende distanzrelevante Signal per Algorithmik vollständig rekonstruiert werden und somit auch dessen genaue Lage bestimmt werden. Die Messung funktioniert auch noch bei sich verändernden Signalen und die Genauigkeit kann durch diesen Ansatz gesteigert werden. Die Voraussetzung führt eine Rekonstruktion ist allerdings, dass der dominante Anteil des Signals innerhalb eines Nyquist-Bandes liegen muss, wobei vorzugsweise das erste Frequenzband verwendet wird.

Andere Verfahren bzw. Vorrichtungen des Stands der Technik halten zwar in erster Näherung die Nyquist- oder Shannon-Bedingung ein. Dabei wird die Bandbreite BW oder der 3dB-Abfallpunkt f3dB des Signalspektrums auf Frequenzen unterhalb der Nyquist-Grenzfrequenz fg limitiert. Da aber aufgrund der niedrigen Filterordnung der Abfall des Spektrums bei Frequenzen oberhalb der BW beziehungsweise f3dB durchwegs zu schwach ausgeprägt ist, ist das Shannon-Theorem nicht zu 100% erfüllt und die Unterdrückung von Aliasing-Effekten für eine präzise, offsetfreie Distanzmessung ist nicht gegeben.

Die Lösungen des Stands der Technik verwenden somit ausgeklügelte Filter-Konzepte, die eine Einhaltung des Abtast-Theorems gewährleisten oder aber sie sind nicht in der Lage, Aliasing-Effekte im für hochpräzise Messungen erforderlichen Masse zu vermeiden.

Die Aufgabe der vorliegenden Erfindung besteht daher in der Bereitstellung eines neuen Distanzmessverfahrens bzw. eines neuen Distanzmessers, welcher diese Nachteile vermeidet oder verringert.

Es ist eine weitere Aufgabe, einen hochgenauen Distanzmesser bzw. ein Distanzmessverfahren ohne Notwendigkeit einer Filterung oder aber einem verringerten Filterungsaufwand vor dem Abtastvorgang bereitzustellen.

Eine weitere Aufgabe besteht darin, einen Distanzmesser bereitzustellen, der auch bei nichtlinear verzerrten Impulsen, wie z.B. bei Signalsättigung, genaue Messungen ermöglicht.

Eine weitere Aufgabe ist es, einen Distanzmesser bereitzustellen, der auch die Nutzung höherfrequenter Signalanteile ermöglicht, insbesondere ohne Beschränkung durch das Shannon-Theorem.

Eine weitere Aufgabe ist es, einen hochgenauen Distanzmesser bereitzustellen, der auch mit vereinfachtem Aufbau, insbesondere mit langsameren Analog-Digital-Wandlern hochgenaue Messung erlaubt.

Insbesondere besteht die Aufgabe, einen Distanzmesser nach dem Laufzeitmessverfahren mit Signalabtastung so weiterzuentwickeln, dass eine absolute Genauigkeit im mm-Bereich oder im sub-mm-Bereich gewährleistet ist. Dabei soll im Idealfall die Präzisionsklasse der Distanzmesser nach dem Phasenmessprinzip erreicht werden.

Diese Aufgaben werden erfindungsgemäss durch die Merkmale der Ansprüche 1 oder 10 bzw. durch die Merkmale der abhängigen Ansprüche gelöst bzw. die Lösungen fortgebildet.

Die Erfindung betrifft Distanzmesser, welche ein Messsignal auf ein in seiner Distanz zu vermessendes Zielobjekt aussenden und nach einer Wechselwirkung mit dem Zielobjekt den zurückgeworfenen Signalanteil als Zielsignal wieder empfangen und auswerten. Typischerweise wird hierzu Licht im sichtbaren oder unsichtbaren Spektralbereich verwendet, das beispielsweise von einer Laserdiode, einem Festkörperlaser, wie z.B. einem Q-switched bzw. gütegeschalteten Microchiplaser, oder einer LED erzeugt wird. Grundsätzlich kann der erfindungsgemässe Ansatz jedoch auch für andere Messsignaltypen Verwendung finden, wie z.B. Ultraschallmesser. Die Distanz wird bei gattungsgemässen Laserdistanzmessern meist nach dem Laufzeitmessprinzip, d.h. aus der zeitlichen Differenz zwischen dem Empfangen des Startsignals und des Zielsignals bestimmt, wobei zumindest das Zielsignal zur Digitalisierung abgetastet wird.

Die erfindungsgemässe Lösung basiert auf einem solchen Ansatz einer Abtastung des Zielsignals durch einen Analog-Digital-Wandler, im Gegensatz zum Stand der Technik werden hierzu jedoch Abtastraten bzw. Frequenzen durch Verstellen gezielt angepasst. Voraussetzung hierfür ist die Kenntnis einer Grobdistanz für die zu vermessende Entfernung zu einem Zielobjekt, welche die Voraussetzung für die nachfolgende Anpassung der Abtastrate darstellt. Eine solche Grobdistanz kann durch eine unmittelbar vorangehende Messung erfolgen, wobei grundsätzlich sowohl Messungen nach einem zur eigentlichen Messung identischen Prinzip als auch nach einem andersartigen Prinzip zur Verwendung kommen können. Ebenso kann die Grobdistanz auch vorgegeben werden, z.B. durch eine Tabelle, in der Zielen Grobdistanzen bzw. die jeweils letzte gemessene Distanz zugeordnet werden. Solche Konstellationen sind bspw. in der Bauwerksüberwachung typisch, bei der für eine grössere Struktur eine Vielzahl von Messpunkten in gewissen Zeitabständen vermessen wird, so dass eine mögliche Veränderung erkannt wird. Für den jeweiligen aktuellen Messvorgang ist dann die Grobdistanz als letzte gemessene Entfernung oder aber als Solldistanz vorbekannt, so dass eine gezielte Wahl einer optimalen Abtastfrequenz anhand der Kenntnis dieser Grobdistanz erfolgen kann.

Ein erfindungsgemäss geeignetes Verfahren zur Grobdistanzmessung ist durch die sogenannten Schwellwertmethode gegeben, bei der ein Lichtpuls als Zielsignal detektiert wird, wenn die Intensität der einfallenden Strahlung einen gewissen Schwellwert überschreitet. Durch diesen Schwellwert wird verhindert, dass Rauschen und Störsignale aus dem Hintergrund fälschlich als Nutzsignal, d.h. als rückgestreutes Licht des emittierten Pulses, detektiert werden. Problematisch ist jedoch, dass bei schwachen rückgestreuten Pulsen, wie sie beispielsweise durch grössere Messdistanzen bedingt werden, eine Detektion nicht mehr möglich ist, wenn die Pulsintensität unter die Detektionsschwelle fällt. Der wesentliche Nachteil dieser Schwellwertmethode liegt somit darin, dass die Amplitude des Messsignals hinreichend grösser als die Rauschamplitude von optischen und elektrischen Rauschquellen im Signalweg sein muss, um Fehldetektionen hinreichend zu minimieren. Eine Grobdistanzmessung nach der Schwellwertmethode kann hierbei zumindest einen Teil der auch für das Abtasten des Signals im nachfolgenden genauen Messverfahren verwendeten Komponenten nutzen, so dass ein geringer Geräteaufwand möglich ist.

Durch die gezielte Wahl einer optimalen Abtastrate werden die relativen Lagen der Abtastpunkte bzw. Samplingpunkte gegenüber dem Signalverlauf so eingestellt, dass Aliasing-Effekte verringert oder unterdrückt werden. Insbesondere erfolgt eine Anpassung der Abtastrate so, dass Signale mit einer identischen relativen Lage gegenüber dem Abtastraster abgetastet werden, wobei als Bezugsgrösse bzgl. der Lage bspw. der Scheitelpunkt eines Signalverlaufs dienen kann. Das Abtasten der gleichen Stellen im Signalverlauf von Ziel- und Startsignal erfolgt somit unter Bezugnahme auf ein charakteristisches Merkmal des Pulsverlaufs, in diesem Fall dem Scheitelpunkt. Die Abtastrate des Analog-Digital-Wandlers und damit die Abtastpunkte eines durch die Abtastrate definierten Abtastrasters werden somit an einen Distanzbereich angepasst, wobei ansonsten durch Aliasing entstehende Effekte wegfallen oder aber algorithmisch berücksichtigt werden können.

Nach dem Abtastvorgang erfolgt die Bestimmung der Distanz mittels Laufzeitverfahren, d.h. anhand einer Zeitmessung zwischen den Signalen, der eine Distanz zugeordnet wird. Typischerweise können hierbei einzelne Pulse ausgesendet werden, erfindungsgemäss ist es jedoch auch möglich komplexere Signalstrukturen bzw. Signalmuster zu verwenden.

Das Einstellen der Abtastrate bzw. Samplingfrequenz kann mit verschiedenen Ansätzen genutzt werden.

Ein erster Ansatz nutzt ein zum Zielsignal korrespondierendes Startsignal, das vor bzw. beim Aussenden des Messsignals erzeugt wird, z.B. durch Verwenden eines internen Referenzpfads, über den ein Teil des Messsignals geräteintern auf den Empfänger geführt wird. Dieses Startsignal wird ebenfalls in zum Zielsignal gleicher Weise vom Empfänger bzw. dem Analog-Digital-Wandler abgetastet. Durch die Veränderung der Abtastrate kann das der jeweiligen Rate zugeordnete Abtastraster so verschoben werden, dass Start- und Zielsignal in gleicher Weise, d.h. an identischen Punkten des Signalverlaufs abgetastet werden. Eine vollständige Rekonstruktion oder Sumbsampling-Interpolation des Pulses ist somit nicht mehr nötig, solange die Abtastrate so gewählt wird, dass der Abstand der beiden Pulse einem ganzzahligen Vielfachen des Abtastintervalls, d.h. des Abstands zwischen den Abtastpunkten, entspricht. Beide Signale werden dann an den gleichen Stellen und somit in direkt vergleichbarer Weise abgetastet. Somit wird die Samplingfrequenz des Analog-Digital-Wandlers in Kenntnis der Grobdistanz so eingestellt, dass beide Signale gleich, d.h. mit gleicher relativer Lage zu den Abtastpunkten, im Samplingraster liegen. Durch Aliasing auftretende Fehler werden beim Abtasten beider Signale, d.h. sowohl von Zielsignal Z als auch vom Startsignal S, dupliziert und können somit bei einem Vergleich beider Signale, ggf. nach einer Amplitudenanpassung, subtrahiert bzw. eliminiert werden.

Um Signale unterschiedlicher Form zu vergleichen kann der Startpuls in der Amplitude mittels variablem optischen Filter angepasst werden bis die Signalform des Startsignals S bis auf einen Skalierungsfaktor mit der Signalform des Zielsignals Z übereinstimmt. Auch in diesem Fall werden die durch Aliasing oder nichtlineare Signalverzerrung auftretenden Fehler auf beiden Signalen Z und S dupliziert und können somit bei einem Vergleich beider Signale wiederum eliminiert werden.

Dieser Ansatz kann auch zur Grobdistanzmessung genutzt werden, wenn bspw. ein erster, noch nicht optimal eingestellter Abtastvorgang als Vormessung zur Bestimmung der Grobdistanz genutzt wird. Anhand der mittels nicht optimaler Abtastung bestimmten Grobdistanz kann dann die für diese Entfernung optimale Abtastrate gewählt werden.

Ein anderer Ansatz betrachtet das Zielsignal in isolierter Weise. Hierzu wird das Abtastraster durch Verändern der Abtastrate gegenüber dem Signalverlauf so eingestellt, dass der Effekt des Aliasing vermindert oder eliminiert wird. Hierzu können vorgängig ermittelte optimale Einstellung bzw. Abtastraten in Tabellenform bereitgehalten werden. In einem solchen Ansatz kann als Startsignal bspw. auch ein elektronisch generiertes Startsignal genutzt werden, das keine Kopie des Zielsignals sein muss. Wird also nur das Zielsignal verwendet, so besteht die Optimierung der Signalposition darin, dieses in eine für die Auswertung optimale Position zum Abtastraster zu setzen. Beispielsweise kann das Zielsignal so in das Abtastraster gelegt werden, dass die erste Ableitung des Zielsignals an einem Abtastpunkt oder einem Set von zeitlichen Intervallen zugeordneten Abtastpunkten möglichst gross ist, was einer Maximierung der Signaländerung pro Distanzänderung entspricht.

Grundsätzlich kann der erfindungsgemässe Ansatz auch mit Verfahren des Stands der Technik kombiniert werden. So können insbesondere auch Filterverfahren, wie sie bspw. in der WO 2011/076907 beschrieben werden, zum Einsatz kommen.

Das erfindungsgemässe Distanzmessverfahren sowie der erfindungsgemäss Distanzmesser werden nachfolgend anhand von in der Zeichnung schematisch dargestellten Ausführungsbeispielen rein beispielhaft näher beschrieben.

Im einzelnen zeigen

Fig.1 ein Blockschaltbild eines Ausführungsbeispiels des erfindungsgemässen Distanzmessers;

Fig.2-3 die Prinzipdarstellung eines Distanzmessers nach dem Laufzeitmessprinzip nach dem Stand der Technik;

Fig.4-5 die Prinzipdarstellung des erfindungsgemässen Distanzmessverfahrens;

Fig.6 die Prinzipdarstellung eines Distanzmessverfahrens nach dem Schwellwertprinzip nach dem Stand der Technik;

Fig.7a-b die unterschiedlichen Spektren für Filter 1. und 2. Ordnung;

Fig.8a-b die unterschiedlichen Spektren für Filter 1. und 2. Ordnung als Funktion der Abtastrate;

Fig.9a-c die Unterschiede zwischen analogem Zeitsignal und aus diesem interpolierten digitalem Signal für ein Filter 1. Ordnung und verschiedene Relativpositionen zwischen Signal und Abtastraster;

Fig.10a-c die Unterschiede zwischen analogem Zeitsignal und aus diesem interpolierten digitalem Signal für ein Filter 2. Ordnung und verschiedene Relativpositionen zwischen Signal und Abtastraster;

Fig.11a-b das Auftreten von Distanzfehlern bei der Abtastung eines Signals mit Filtern verschiedener Ordnung und Relativpositionen zwischen Signal und Abtastraster;

Fig.12a-b die Erläuterung der Gesamtfehler für Distanzmessverfahren des Stands der Technik gegenüber dem erfindungsgemässen Distanzmessverfahren;

Fig.13 die Prinzipdarstellung einer erfindungsgemässen linearen Interpolation des Stopp-Signals und

Fig.14 die Prinzipdarstellung einer erfindungsgemässen Erstellung einer Look-Up-Tabelle.

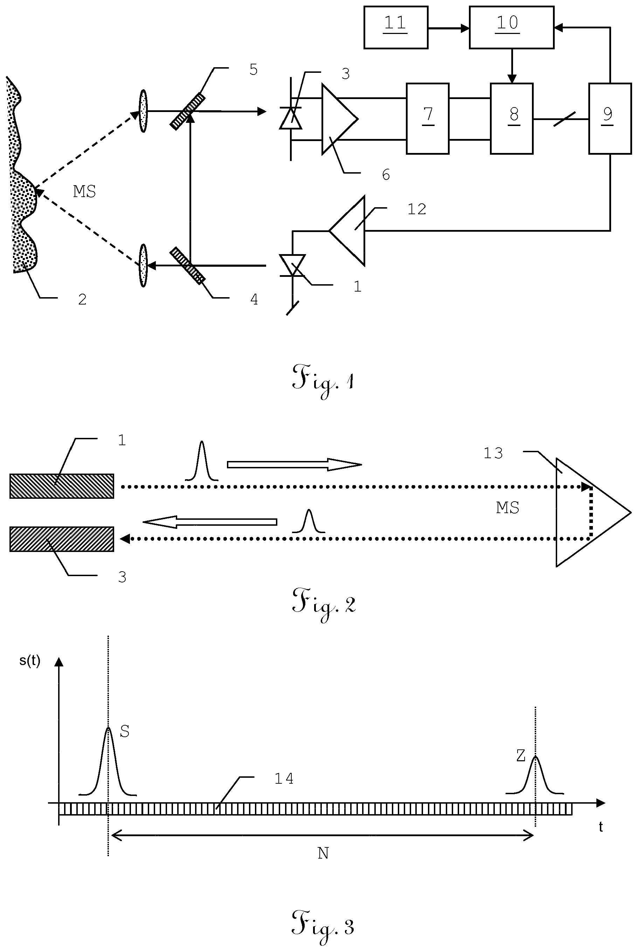

Fig.1 zeigt ein Blockschaltbild eines Ausführungsbeispiels des erfindungsgemässen Distanzmessers. Der Distanzmesser weist wenigstens eine Messsignalquelle 1 zum Aussenden wenigstens eines Messsignals MS, insbesondere eines Lichtsignals, auf ein Zielobjekt 2 auf, wobei wenigstens ein Startsignal erzeugt wird. Als Messsignalquelle 1 kommen insbesondere Laserdioden, Festkörperlaser oder LEDs in Frage. Das Startsignal kann als elektronisch generiertes Signal bereitgestellt werden oder aber, wie in diesem Ausführungsbeispiel, durch Teilen oder Umschalten des Messsignals MS erzeugt werden. Hierzu wird das Messsignal MS bspw. über einen Strahlteiler 4 geführt und nachfolgend auf das Zielobjekt 2 emittiert. Der andere Teil des Messsignals MS wird über einen geräteinternen Referenzpfad zu einem weiteren Strahlteiler 5 geführt und dort wieder in den Empfangstrahlengang eingekoppelt. Durch diese Anordnungen werden somit eine geräteexterne Messstrecke und eine geräteinterne Referenzstrecke definiert, wobei das Startsignal durch Auskoppeln und die geräteinterne Strahlführung bereitgestellt wird. Neben der Auskopplung mittels Strahlteiler 4 kann auch ein aufeinanderfolgendes Durchlaufen von geräteexterner Messstrecke und geräteinterner Referenzstrecke realisiert werden, z.B. durch ein Umschaltelement, das jeweils nur eine der Strecken freigibt und hin- und hergeschaltet wird.

Das vom Zielobjekt 2 zurückgeworfene Messsignal MS wird auf einen Empfänger 3 zum Detektieren geführt, wo es als Zielsignal detektiert und nach einer Verstärkerstufe 6 von einer nachfolgenden Abtastschaltung mit einem Analog-Digital-Wandler 8 zur Bestimmung der relativen Lage von Start- und Zielsignal abgetastet wird. Vor dem Abtasten durch den Analog-Digital-Wandler 8 kann eine Filterung durch einen Tiefpass- oder Bandpass Filter 7 erfolgen. Die Distanz zum Zielobjekt wird in einer Steuer- und Auswertekomponente 9 aus der relativen Lage von Start- und Zielsignal bestimmt.

Die Abtastschaltung ist hierzu so ausgebildet, dass das Zielsignal mit einer ver- und einstellbaren Abtastrate abgetastet wird, so dass die Abtastrate und damit das Abtastverhalten an eine vorbekannte oder vorgängig ermittelte Grobdistanz zum Zielobjekt 2 anpassbar ist. Dabei wird der Analog-Digital-Wandler 8 durch die Steuer- und Auswertekomponente 9 über einen Frequenzgenerator 10, insbesondere einen Synthesizer, vorzugsweise einen Direct Digital Synthesizer oder einem spannungsgesteuerten und auf einer Phasenregelschleife-basierten Integer-N-Synthesizer, mit Reference-Clock 11 zur Frequenzsynthese gesteuert. Die Steuer- und Auswertekomponente 9 steuert zudem über eine Verstärkerstufe 12 die Messsignalquelle 1, wobei über einen weiteren, hier nicht dargestellten Frequenzgenerator auch die Frequenz der Messsignalquelle 1 entsprechend verstellt werden kann, so dass sowohl die Frequenzen von Empfänger als auch Quelle entsprechend angepasst werden können. Je nach Ausgestaltung kann die Abtastrate manuell oder vorzugsweise automatisch eingestellt bzw. an die Grobdistanz angepasst werden.

In diesem Ausführungsbeispiel erfolgt die Grobdistanzmessung nach dem gleichen Prinzip wie die nachfolgende präzisere Messung, so dass zwei jeweils über geräteexterne Messstrecke und geräteinterne Referenzstrecke geführte Messsignale nacheinander mit unterschiedlichen Abtastraten abgetastet. Hierbei werden bei jedem Abtastvorgang Start- und Zielsignal gemeinsam mit einer Abtastrate in einem Vorgang analysiert. Der erste Abtastvorgang liefert somit die Grobdistanzmessung anhand derer nachfolgend die Abtastrate für den zweiten, genaueren Messvorgang gezielt eingestellt wird.

Alternativ kann die Grobdistanzmessung auch mit einer hier nicht dargestellten laufzeitmessenden Messschaltung realisiert werden, die so ausgebildet ist, dass eine Detektion des zurückgestreuten Messsignals MS erfolgt, wenn dessen Intensität einen vorgegebenen Schwellwert überschreitet. Für eine solche Messung kann zumindest ein Teil der für die Feinmessung verwendeten Komponenten genutzt werden. Eine erfindungsgemäss geeignete Integration von abtastender und schwellwertmessender Funktionalität wird beispielsweise in der WO 2008/009387 beschrieben.

Allerdings ist es erfindungsgemäss ebenso möglich, eine eigene Grobdistanz-Messsignalquelle und einen Grobdistanz-Empfänger zu verwenden, wobei diese so ausgebildet und angeordnet sind, dass sie einen von der Messsignalquelle und dem Empfänger unabhängigen zweiten Messpfad definieren. Neben der Schwellwertmethode können auch andere Distanzmessverfahren des Stands der Technik verwendet werden, beispielsweise Verfahren nach dem Triangulationsprinzip.

Ebenso können die Grobdistanzen auch aus einer Speichereinheit zum Speichern von Grobdistanzen für vorbekannte Zielobjekte entnommen werden. Solche Lösungen sind insbesondere geeignet, wenn statische oder in ihrer Position bekannte Zielobjekte mehrfach vermessen werden sollen, wie dies beispielsweise bei der Bauwerksüberwachung oder bei der Prüfung von Masshaltigkeiten der Fall ist. Hier sind die Grobdistanzen als Ergebnisse früherer Messungen oder als vorgegebene Sollgrössen bekannt, so dass für jeden Messvorgang anhand dieser Werte ohne unmittelbar vorhergehende Grobmessung direkt eine geeignete bzw. optimale Abtastrate gewählt und eingestellt werden kann.

In Fig.2-3 wird das Laufzeitmessprinzip für einen Pulslaufzeit-Distanzmesser nach dem Stand der Technik erläutert. In dem Distanzmesser sind die Messsignalquelle 1 und der Empfänger 3 angeordnet. Die Messsignalquelle 1 emittiert einen Lichtpuls, der nach der Reflektion bzw. Rückstreuung an einem Ziel, z.B. einem Retroreflektor 13, wieder als zurückgestreuter Lichtpuls vom Empfänger 3 detektiert wird. Anstelle der Lichtpulse kann auch ein Muster, z.B. aus einer Folge von Pulsen oder ein Rechtecksignal, als Messsignal verwendet werden. Beim Aussenden wird ein Teil des Messsignals zur Erzeugung des Startsignals S über die geräteinterne Referenzstrecke geführt, so dass dieses zeitlich früher als das vom Zielobjekt zurückgeworfene Zielsignal Z empfangen wird. Diese Situation wird in Fig.3 veranschaulicht, wobei die Signalimpulses s (t) gegen die Zeit t aufgetragen sind und als Signalformen Pulse gezeigt werden. Startsignal S und Zielsignal Z werden von einem Analog-Digital-Wandler mit einer Abtastrate gemeinsam abgetastet, wobei beide Signale in einem durch die Abtastrate definierten Abtastraster aus Abtastintervalle 14 liegen und durch eine Zahl N von Abtastintervallen beabstandet sind. In Verfahren des Stands der Technik werden nun Startsignal S und Zielsignal Z an den Abtaststellen erfasst, die Signale rekonstruiert und deren zeitliche Abstand bestimmt, wozu grundsätzliche verschiedene Verfahren, wie z.B. Kreuzkorrelation zwischen den Signalen S und Z oder zwischen Messimpulsen und im Speicher abgelegten Musterimpulsen, zur Verfügung stehen. Aus dem zeitlichen Abstand, d.h. der Signallaufzeit über die geräteexterne Messstrecke, wird dann in bekannter Weise die zugehörige Distanz zum Ziel bestimmt.

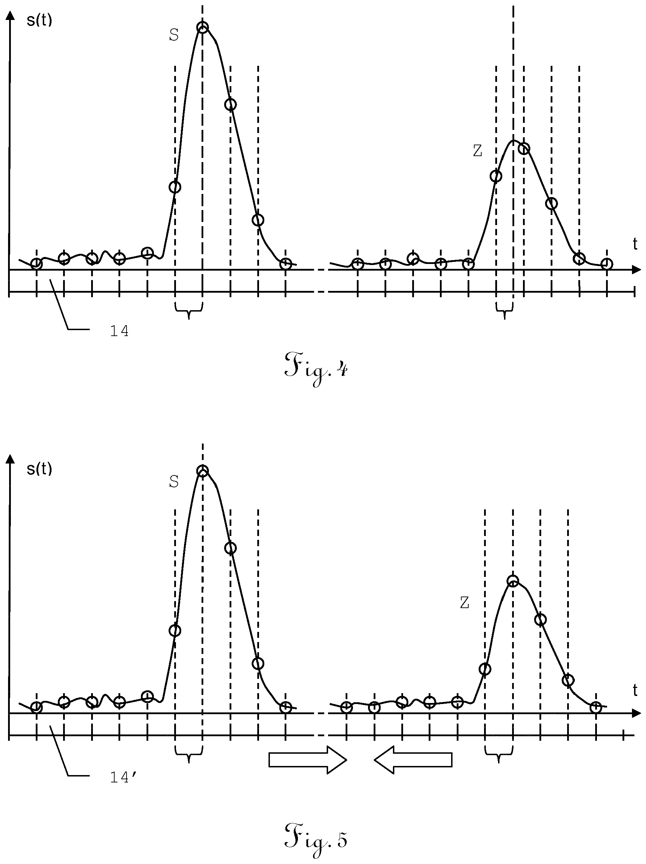

Fig.4-5 erläutern das erfindungsgemässe Distanzmessprinzip. Gezeigt werden die zu Fig.3 korrespondierenden vergrösserten Ausschnitte für das Startsignal S und das Zielsignal Z, wobei in diesem Beispiel das Zielsignal Z als abgeschwächte Kopie des Startsignals S gezeigt wird. In der Realität können jedoch für das Zielsignal Z noch Verzerrungen auftreten. In Fig.4 ist zu erkennen, dass Startsignal S und Zielsignal Z unterschiedliche relative Lagen gegenüber dem durch Abtastintervalle 14 definierten Abtastraster aufweisen, wobei die Abtastintervalle 14 die Zeiträume und damit Abstände zwischen zwei Abtastpunkten darstellen. So fällt für das Startsignal S der Scheitelpunkt mit einem Abtastpunkt zusammen, wohingegen der Scheitelpunkt für das Zielsignal Z im Abtastintervall und somit zwischen zwei Abtastpunkten zu liegt. Somit werden beide Signale an unterschiedlichen Punkten ihres Signalverlaufs abgetastet und es können bei der Subsampling-Interpolation Aliasing-Effekte auftreten, die zu Fehlern in der Distanzmessung führen.

Erfindungsgemäss wird der gleiche Signalverlauf, d.h. eine Kopie von Startsignal S und Zielsignal Z erneut oder parallel abgetastet, wobei in Kenntnis der Grobdistanz eine passende Abtastrate mit zugeordnetem Abtastraster ausgewählt, eingestellt und zur präzisen Messung verwendet wird, so dass eine Abtastung an anderen Stellen des Signalverlaufs erfolgt. Im Beispiel der gemeinsamen Abtastung von Startsignal S und Zielsignal Z verschieben sich diese Abtaststellen entlang des Signalverlaufs. Eine erfindungsgemäss gewünschte Situation tritt dann auf, wenn die in Fig.5 gezeigte Verkürzung der Abtastintervalle 14' dazu führt, dass Startsignal S und Zielsignal Z mit gleicher Phasenlage, d.h. ohne Phasenverschiebung zueinander abgetastet werden. In diesem Fall werden Flanken und Scheitelpunkte der beiden Signale in gleicher Weise abgetastet, so dass beide Signale relativ zum Abtastraster gleich positioniert sind. Es ist erfindungsgemäss ebenfalls möglich, den Sende- sowie Empfangs- und Abtastvorgang mehrfach zu wiederholen und die abgetasteten Werte für Startsignal S und/oder Zielsignal Z vor Bestimmung deren zeitlichen Abstandes zu akkumulieren.

Neben der Verwendung von Grobdistanzen aus geräteexternen Informationen oder aufgrund einer Grobdistanzmessung mit andersartigen Verfahren kann die Abtastrate für das zweite Abtasten auch basierend auf einem Ergebnis eines ersten Abtastens gewählt werden und somit aufgrund einer auf dem ersten Abtasten basierenden Grobdistanz zum Zielobjekt. Erfindungsgemäss geeignete, jedoch nicht abtastende Verfahren für eine Grobdistanzmessung sind z.B. eine Pulslaufzeitmessung nach der Schwellwertmethode oder Triangulationsverfahren. Bei Messaufgaben mit einer Abfolge von vielen Messungen und nicht zu stark strukturierten Objekten können beispielsweise auch vorangegangene Messungen zu benachbarten Punkten als Grobdistanzen verwendet werden. Die Auswahl der Abtastrate kann dabei erfolgen, indem diese einer Tabelle entnommen wird, in der Grobdistanzen geeignete Abtastraten zugeordnet werden. Solche Tabellen können insbesondere auf der Basis vorangegangener Distanzmeßvorgänge, wie z.B. bei der Bauwerksüberwachung, oder aus der Vorgabe von zu prüfenden oder zu überwachenden Solldistanzen erstellt werden.

Bei Vorliegen einer Grobdistanz und einer vorgegebenen gewünschten Abtastauflösung mit zugehöriger Vorgabe-Abtastrate kann dann die Abtastrate für die Feinmessung gemäss folgender Beziehung eingestellt werden

$$f = \lfloor N \rfloor \cdot \frac{c}{2D}$$

wobei *f* die einzustellende Abtastrate für das Abtasten, *c* die Lichtgeschwindigkeit im Transmisssionsmedium Luft, *D* die Grobdistanz und $\lfloor N \rfloor$ die Abrundungsfunktion für die Zahl der Abtastintervalle 14 zwischen dem Startsignal S und dem Zielsignal Z bezeichnet, die sich bei der vorgegebenen Abtastauflösung entsprechenden Rate ergeben.

Die Vorgabe-Abtastrate dient als Ausgangsgrösse für die dann in Hinblick auf die Optimalität anzupassende und einzustellende Fein-Abtastrate, wobei diese zumeist geringfügig niederfrequenter als die Vorgabe-Abtastrate gewählt wird. Grundsätzlich ist jedoch auch eine Anpassung zu höherfrequenten Abtastraten möglich.

Die Abtastrate für das zweite Abtasten kann jedoch auch mit einem identischen Verfahren für die Grobdistanzmessung gemäss folgender Beziehung gewählt werden

$$f_{n+1} = f_n \cdot \lfloor N \rfloor / N$$

wobei $f_{n+1}$ die zu wählende Abtastrate für das zweite Abtasten, $f_n$ die Abtastrate für das erste Abtasten, $N$ die Zahl der Abtastintervalle 14 zwischen dem Startsignal S und dem Zielsignal Z und $\lfloor N \rfloor$ die Abrundungsfunktion für die Zahl der Abtastintervalle 14 zwischen dem Startsignal S und dem Zielsignal Z bei fn bezeichnet.

Bei einer Startabtastrate bzw. -frequenz von $f_n$ = 500 MHz ergibt sich beispielsweise N = 789.358 als Zahl der zwischen Startsignal und Zielsignal gelegenen Abtastintervalle.

Die zugehörige Distanz D kann gemäss

$$D = \frac{N}{f_n} \cdot \frac{c}{2} = 236{,}807m$$

berechnet werden, wobei c die Lichtgeschwindigkeit bezeichnet.

Die zu wählende zweite Abtastrate ergibt sich gemäss

$$f_{n+1} = f_n \cdot \lfloor N \rfloor / N = 500MHz \cdot \frac{789}{789{,}358} = 499{,}773MHz$$

Vorrichtungsseitig wird dies realisiert, indem die Abtast- bzw. Samplingfrequenz des Analog-Digital-Wandlers mit einem Frequenzgenerator, wie z.B. einem Synthesizer (N, Fractional-N oder DDS (Direct Digital Synthesizer)) erzeugt wird. Begrenzt wird dieser Ansatz durch die Einstellgenauigkeit des Frequenzgenerators und die Güte der vorangegangenen Distanzmessung bzw. der vorangegangenen Abtastungen.

Erfindungsgemäss kann die zu wählende Abtastrate aber auch in analoger Weise mittels Aufrundungsfunktion $\lceil N \rceil$ gewählt werden, so dass sich folgende alternative Beziehungen ergeben:

$$f = \lceil N \rceil \cdot \frac{c}{2D} \quad \text{oder} \quad f_{n+1} = f_n \cdot \lceil N \rceil / N$$

Eine andere erfindungsgemässe Möglichkeit besteht darin, die Abtastrate für das zweite Abtasten solange zu verändern, bis die erste Ableitung des Signals bzw. des Signalimpulses an den Abtastpunkten des Zielsignals Z maximal ist bzw. die Veränderung zu beenden, wenn die sich die erste Ableitung wieder verringert. Dieser Ansatz kann somit auf die ausschliessliche Betrachtung der Veränderungen des Zielsignals Z beschränkt werden und erlaubt somit auch die Verwendung eines elektronisch erzeugten Startsignals S, das sich somit in seiner Charakteristik und seiner Signalverarbeitung vollständig vom Zielsignal Z unterscheiden kann.

Dieser Ansatz der Abtastung mit wenigstens zwei unterschiedlichen Abtastraten kann erfindungsgemäss auch mit einer Filterung kombiniert werden, wie sie beispielsweise in der WO 2011/076907 beschrieben wird, so dass vor der Digitalisierung eine Filterung erfolgt.

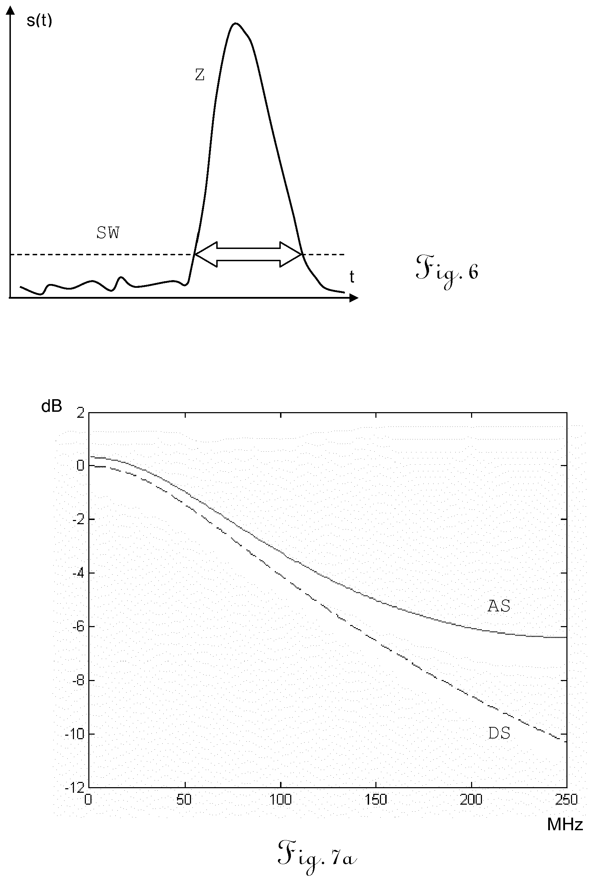

In Fig.6 wird ein für die Grobdistanzmessung geeignetes Schwellwertverfahren für zurückgestreute Lichtsignale als Zielsignal Z nach dem Stand der Technik erläutert, wie es beispielsweise auch in der WO 2008/009387 beschrieben ist. Um Rauschen, Hintergrundanteile oder systematische Störsignale wie beispielsweise durch das optische und elektrische Übersprechen zwischen Sendersignalweg und Empfängersignalweg zu unterdrücken und von einer Detektion auszuschliessen, wird eine Detektionsschwelle SW verwendet. Unterhalb dieser Detektionsschwelle SW liegende Signalintensitäten s(t) führen nicht zu einem Ansprechen der ein Stoppsignal generierenden Empfangseinheit auf das Zielsignal Z und somit nicht zu einer Detektion. Überschreitet das Zielsignal Z in seiner Intensität die Detektionsschwelle SW erfolgen die Detektion und damit die Erzeugung des Stoppsignals und die Registrierung des Empfangszeitpunktes. Das von dem Schwellwertverfahren bereitgestellte Ausgangsignal ist somit abhängig vom Erreichen bzw. Überschreiten der Detektionschwelle SW durch das empfangene Zielsignal Z.

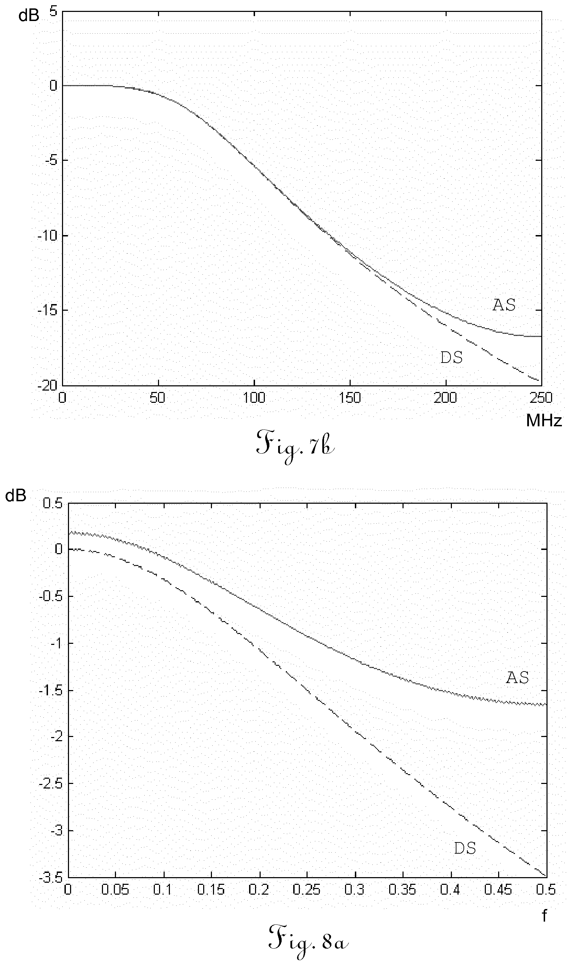

Die unterschiedlichen Spektren geeigneter Filter erster und zweiter Ordnung werden in Fig.7a-b dargestellt, wobei es sich um Tiefpass-Typen mit einer 3dB-Grenzfrequenz BW von 80MHz bei einer Abtastrate von 500 MHz handelt. Auf der horizontalen Achse ist die Frequenz in MHz und auf der vertikalen Achse die Abschwächung in dB angegeben, wobei die durchgezogene Linie das analoge Signal AS und die gestrichelte Linien das digitale Signal DS darstellen. Fig.7a zeigt ein Filter erster Ordnung, Fig.7b ein Filter zweiter Ordnung.

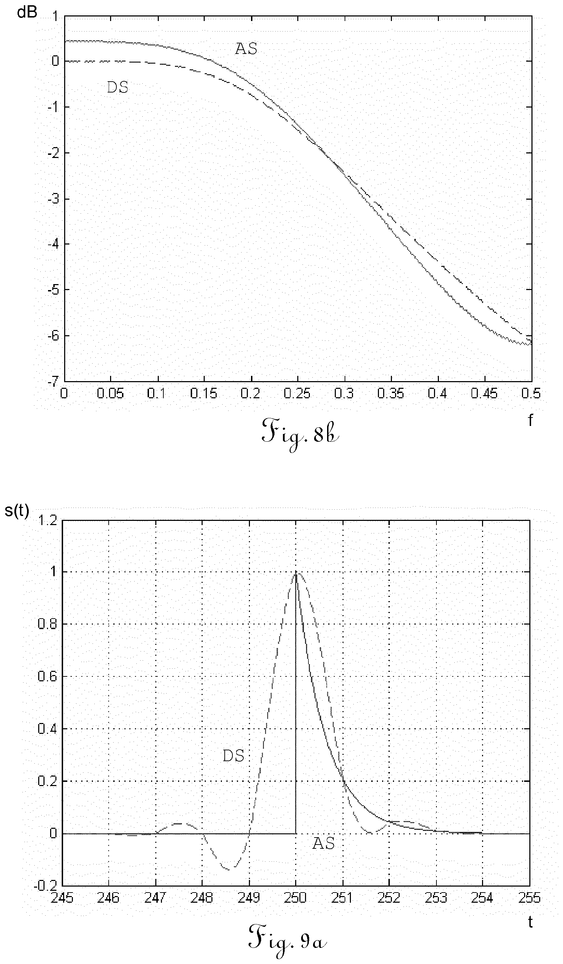

Die Spektren derselben Filter werden in den Fig.8a-b als Funktion der Abtastrate gezeigt, wobei auf der vertikalen Achse die Frequenz in Einheiten der Abtastrate angegeben.

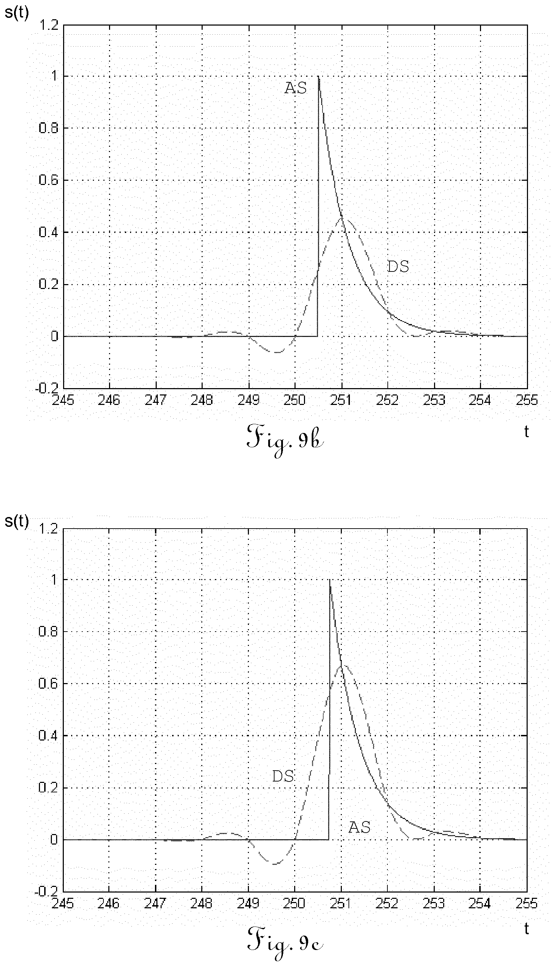

Die Fig.9a-c veranschaulichen die Unterschiede zwischen analogen Zeitsignal AS und aus diesem interpolierten digitalen Signal DS für ein Filter erster Ordnung und verschiedene beispielhafte Relativpositionen zwischen Zeitsignal und Abtastraster. Das durchgezogen gezeichnete analoge Zeitsignal AS wird in den Fig.9a-c an drei unterschiedlichen Positionen gegenüber dem Abtastraster dargestellt. In Fig.9a liegt das Maximum des Zeitsignals exakt auf dem mit der Zeiteinheit 250 markierten Abtastpunkt des Abtastrasters, wobei das aus dem abgetasteten Zeitsignal AS interpolierte digitale Signal DS an den Abtastpunkten identische Werte aufweist und in den Zwischenbereichen abweicht. Bei Fig.9a liegt das Maximum des Zeitsignals AS direkt im Abtastraster, wobei auch das Maximum des digitalen Signals DS als Rekonstruktion an dieser Stelle zu liegen kommt. In den folgenden Fig.9b-c verschiebt sich die zeitliche Lage des Zeitsignals AS relativ zum Abtastraster nach rechts, so dass das Maximum des Zeitsignals AS nunmehr zwischen den Abtastpunkten mit den Zeiteinheiten 250 und 251 zu liegen kommt. Es ist zu erkennen, dass bei diesen verschiedenen Relativpositionen auch unterschiedliche Lagen von Maximum und Schwerpunkt des digitalen Signals DS folgen, so dass eine Abhängigkeit der Signalrekonstruktion von der Relativposition des Zeitsignals AS im Abtastraster entsteht, welche zu Distanzfehlern führt.

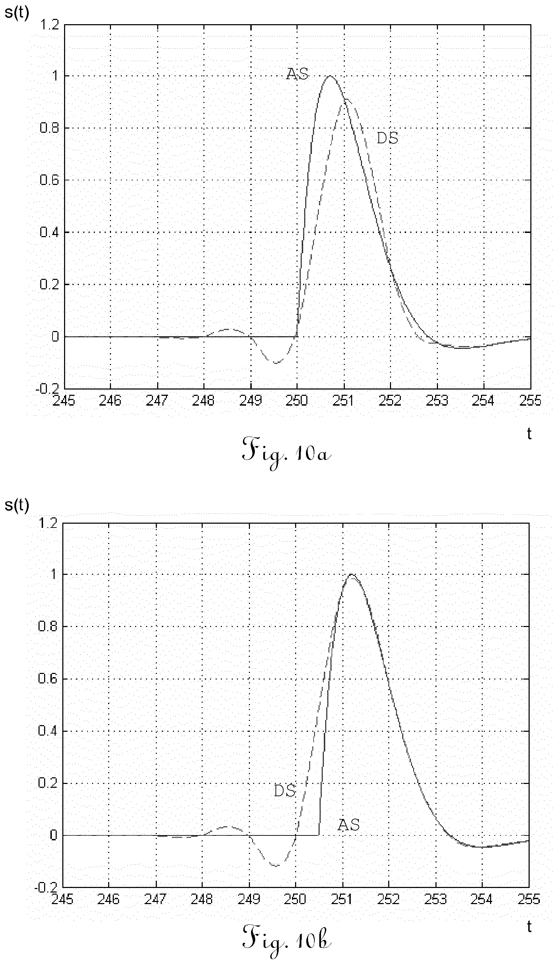

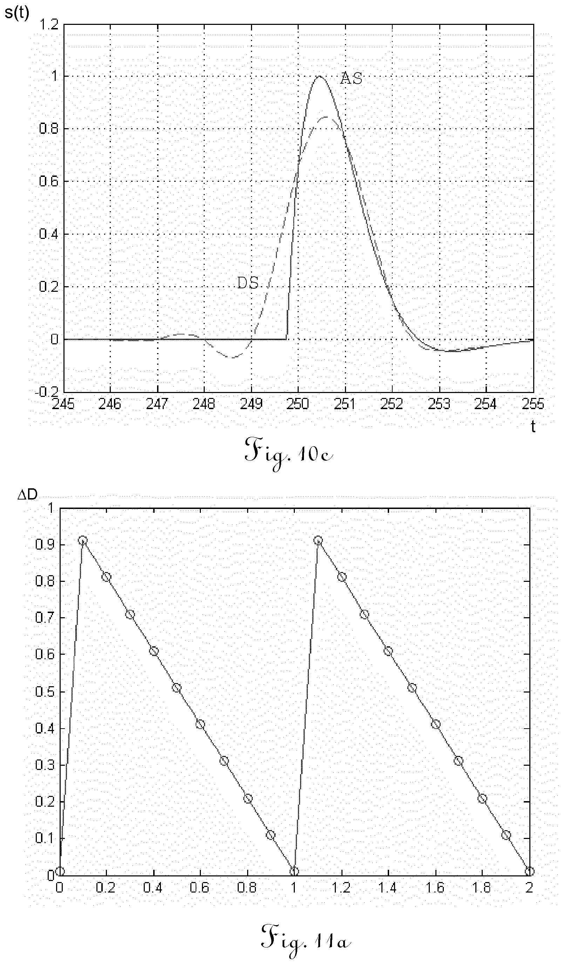

In den Fig.10a-c werden die entsprechenden Unterschiede zwischen analogen Zeitsignal und aus diesem interpolierten digitalen Signal für ein Filter zweiter Ordnung gezeigt, wobei aufgrund der Filterung die Abweichungen zwischen den Signalverläufen und damit auch die Distanzfehler geringer ausfallen.

In den Fig.11a-b wird das Auftreten von Distanzfehlern $\Delta D$ bei der Abtastung eines Signals mit Filtern verschiedener Ordnung und Relativpositionen zwischen Signal und Abtastraster dargestellt. Gezeigt wird der durch die unterschiedlichen relativen Rasterlagen entstehende Fehler bei der Bestimmung der zeitlichen Lage des zu rekonstruierenden Signals relativ zu einem Referenzzeitpunkt, wobei aus der zeitlichen Lage über die Signallaufzeit die zu bestimmende Distanz folgt. Erkennbar wird der Distanzfehler der entsteht, wenn die Position über ein digital interpoliertes Signal bestimmt wird. Als Zeitposition wird die Position der Maximalwerte des analogen und des digital Interpolierten Signals angenommen. Auf der vertikalen Achse wird der Distanzfehler $\Delta D$ als Unterschied zwischen der Position der Maximalwerte gezeigt.

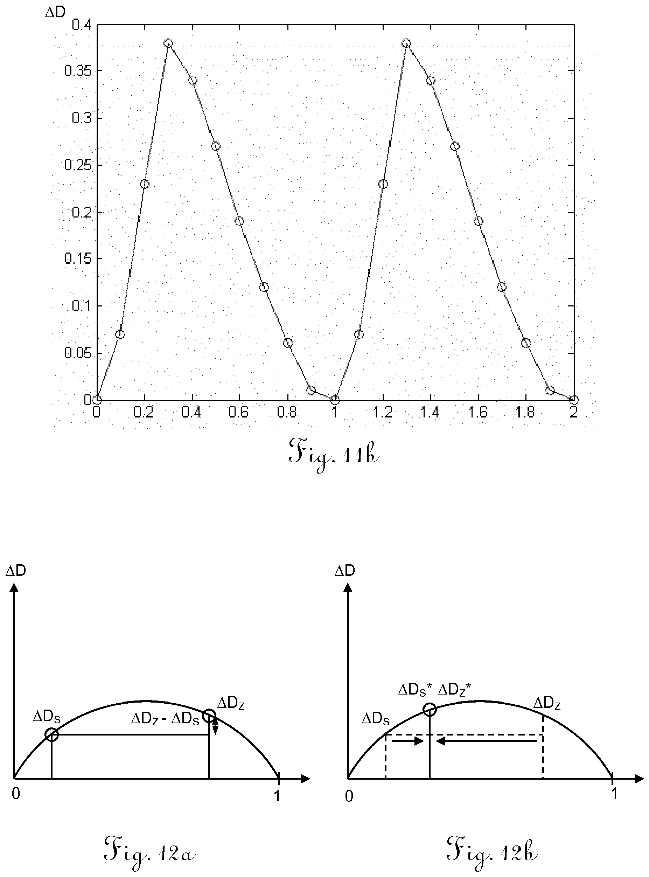

Die horizontale Achse bezeichnet die Verschiebung des Abtastrasters in Einheiten des Abstands der Abtastpunkte, d.h. die Verschiebung des Signals gegenüber dem Abtastraster. Beim in Fig.11a dargestellten Fall des Filters erster Ordnung ist erkennbar, dass der Fehler linear ansteigt und die wahre Distanz nur für den Fall der Übereinstimmung von Maximalwert und Abtastpunkt gegeben ist. In Fig.11b wird die gleiche Situation für ein Filter zweiter Ordnung gezeigt.

Bei der bisherigen Betrachtung ist der Fehler, der sich ggf. aus der zusätzlich erfolgenden Abtastung eines Startsignals oder eines anderen Referenzsignals ergibt, ausser Betracht. Dieser wird nachfolgend in den Fig.11a-b erläutert.

Die Fig.12a-b erläutern den Gesamtfehler für Distanzmessverfahren des Stands der Technik gegenüber dem erfindungsgemässen Distanzmessverfahren.

Fig.12a veranschaulicht die durch Aliasing-Effekte gestörte Subsampling-Interpolation und dadurch entstehenden Fehler $\Delta D_S$ für das Startsignal und den Fehler $\Delta D_Z$ für das Zielsignal. Gezeigt wird hierbei der innerhalb eines Abtastintervalls auftretende Distanzfehler $\Delta D$ gegenüber der aufgrund der Periodizität im Intervall Null bis Eins angegebenen Verschiebung bzw. relativen Lage des Signalschwerpunkts zum Abtastraster. Wie auch im Stand der Technik bekannt ist, entstehen beim Rekonstruieren oder Interpolieren eines Signals Aliasing-Fehler. Diese sind im Allgemeinen um so grösser je weiter die Signalschwerpunkte gegenüber einem Abtastpunkt des Samplingrasters verschoben sind. Anstelle eines Signalschwerpunkts kann alternativ irgendeine die Laufzeit repräsentierende Signatur des Signals genommen werden. Werden zwei Signale miteinander verglichen, entsteht abhängig von der Differenz ihrer Abtastzeitpunkte ein mehr oder weniger grosser Gesamtfehler $\Delta D_Z$ - $\Delta D_S$ der zu bestimmenden Distanz.

Werden Startsignal und Zielsignal hingegen mit gleicher relativer Lage bzw. Phasenverschiebung gegenüber dem Abtastraster abgetastet, so verringert sich aufgrund der Differenzbildung der resultierende Fehler, wie dies in Fig.9b für die durch die Einstellung der Abtastrate bewirkte Verschiebung der Fehler $\Delta D_S$ und $\Delta D_Z$ für Start- und Zielsignal zu $\Delta D_S$* und $\Delta D_Z$* gezeigt wird. Die fraktionale Verschiebung innerhalb des Abstastintervalls ist für Start- und Zielpulse identisch, damit wird in diesem Fall auch die Differenz $\Delta D_S$* - $\Delta D_Z$* als Gesamtfehler Null.

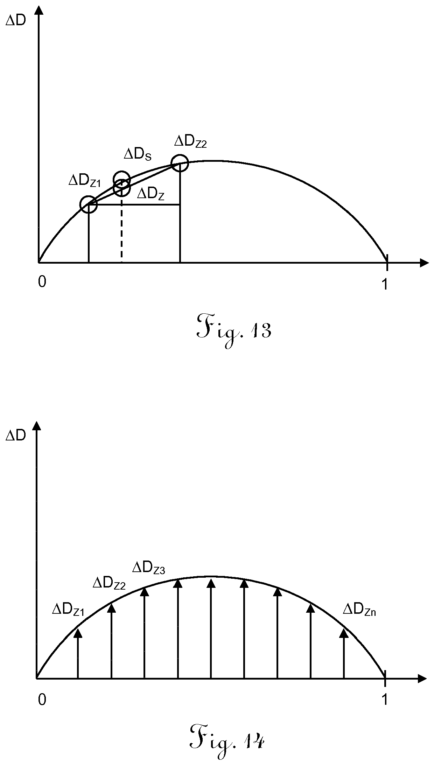

Zusätzlich können die durch Aliasing auftretenden Fehler auch durch Mehrfachmessung der gleichen Distanz mit zusätzlichen Abtastraten identifiziert bzw. verringert oder gänzlich eliminiert werden. Eine erste Möglichkeit wird in Fig.13 in Form einer linearen Interpolation des Zielsignals bzw. Stopp-Signals veranschaulicht. In diesem Beispiel wird das Zielsignal zusätzlich mit weiteren unterschiedlichen Raten zweifach abgetastet, wobei diese so gewählt werden, dass die resultierenden zeitlichen Verschiebungen auf beiden Seiten des ebenfalls abgetasteten Startsignals liegen. Aus den Messungen werden somit die beiden Distanzfehler $\Delta D_{Z1}$ und $\Delta D_{Z2}$ für die beiden Zielsignale und der Distanzfehler $\Delta D_S$ für das in seiner Relativlage zum Abtastraster unveränderte Startsignal erfasst. Auch wenn die beiden Werte $\Delta D_{Z1}$ und $\Delta D_{Z2}$ nicht explizit vorliegen, ist die Differenz $\Delta D_{Z1}$ - $\Delta D_{Z2}$ und mit den zugehörigen Zeitverschiebungen (Subintervallen) bekannt. Aus der Differenz der beiden Distanzfehlern $\Delta D_{Z1}$ und $\Delta D_{Z2}$ kann nachfolgend durch lineare Interpolation ein synthetischer Distanzfehler $\Delta D_Z$ als interpolierter und nicht direkt gemessener Wert für ein um den gleichen Betrag wie das Startsignal gegenüber dem Abtastraster verschobenes Zielsignal berechnet werden. Mit Hilfe dieses synthetischen Wertes kann dann der Fehler weitgehend oder vollständig eliminiert werden

Um die Distanzmessgenauigkeit noch weiter zu steigern, können die bei entsprechenden Verschiebungen gegenüber dem Abtastraster auftretenden systematischen Distanzfehler für verschiedene Abtastraten, Messdistanzen und Konfigurationen (z.B. unterschiedliche Ziel- und Signalformen) bestimmt und erfindungsgemäss in einer Tabelle abgelegt werden. Dieser Fall ist in Fig.14 in Form einer Prinzipdarstellung einer erfindungsgemässen Erstellung einer Look-Up-Tabelle gezeigt, bei der für eine unveränderte Distanz und Messkonfiguration die verschiedenen Distanzfehler $\Delta D_{Z1}$, $\Delta D_{Z2}$, $\Delta D_{Z3}$ bis $\Delta D_{Zn}$ für n diskrete Abtastraten und daraus resultierend n Verschiebungen gegenüber dem Abtastraster bestimmt werden. Beispielsweise kann durch Mehrfachmessungen der gleichen Distanz mittels mehreren unterschiedlichen Frequenzen die vollständige Kurve $\Delta D$ über das gesamte Intervall zwischen zwei Abtastpunkten aufgenommen werden. In Fig.14 ist das Ergebnis aus einer Serie von n Messungen mit äquidistanten Verschiebungen dargestellt.

## Patentansprüche

**1.** Distanzmessverfahren, insbesondere nach dem Laufzeitmessverfahren, mit wenigstens einem

- Aussenden wenigstens eines Messsignals (MS), insbesondere eines Lichtsignals, auf ein Zielobjekt (2,13), wobei wenigstens ein Startsignal (S) erzeugt wird;
- Empfangen des vom Zielobjekt (2,13) zurückgestreuten Messsignals (MS) als Zielsignal (Z);
- Abtasten des empfangenen Zielsignals (Z) mit einer Abtastrate und Bestimmen der relativen Lage von Startsignal (S) und Zielsignal (Z), wobei das Zielsignal (Z) an Abtastpunkten eines der Abtastrate zugeordneten Abtastrasters abgetastet wird;
- Ableiten einer Distanz zum Zielobjekt (2, 13) aus der relativen Lage von Startsignal (S) und Zielsignal (Z);

**dadurch gekennzeichnet, dass** die Abtastrate verstellbar ist und in Abhängigkeit von einer Grobdistanz zum Zielobjekt eingestellt wird.

**2.** Distanzmessverfahren nach Anspruch 1,
**dadurch gekennzeichnet, dass**
die Abtastrate so eingestellt wird, dass eine jeweilige Lage von Startsignal (S) und Zielsignal (Z) relativ zu dem Abtastraster gleich ist, so dass Start- und Zielsignal an gleichen Stellen des jeweiligen Signalverlaufs abgetastet werden.

**3.** Distanzmessverfahren nach Anspruch 1 oder 2,
**dadurch gekennzeichnet, dass**
die Abtastrate gemäss einer der folgenden Beziehungen eingestellt wird

$$f = \lfloor N \rfloor \cdot \frac{c}{2D} \quad \text{oder} \quad f = \lceil N \rceil \cdot \frac{c}{2D}$$

wobei

$f$ die einzustellende Abtastrate für das Abtasten,
$c$ die Lichtgeschwindigkeit,
$D$ die Grobdistanz,
$N$ die Zahl der Abtastintervalle zwischen dem Start- und dem Zielsignal,
$\lfloor N \rfloor$ die Abrundungsfunktion und
$\lceil N \rceil$ die Aufrundungsfunktion für die Zahl der Abtastintervalle zwischen dem Start- und dem Zielsignal bezeichnen.

**4.** Distanzmessverfahren nach einem der vorangehenden Ansprüche,
**dadurch gekennzeichnet, dass**
ein synthetischer Distanzfehler für das Zielsignal (Z) bestimmt wird, insbesondere durch lineare Interpolation eines in seiner Lage verschobenen Zielsignals (Z).

5. Distanzmessverfahren nach einem der vorangehenden Ansprüche,
**dadurch gekennzeichnet, dass**
die Grobdistanz zum Zielobjekt (2,13) durch eine Grobdistanzmessung ermittelt wird.

6. Distanzmessverfahren nach Anspruch 5,
**dadurch gekennzeichnet, dass**
das Aussenden, Empfangen und Abtasten für ein erstes und ein zweites Messsignal erfolgen, wobei aus dem ersten Messsignal eine Grobdistanz abgeleitet wird und die Abtastrate für das Abtasten des zweiten Messsignals in Abhängigkeit der so ermittelten Grobdistanz eingestellt wird.

7. Distanzmessverfahren nach Anspruch 5 oder 6,
**dadurch gekennzeichnet, dass**
die Grobdistanz zum Zielobjekt (2,13) in Abhängigkeit von der Laufzeit ermittelt wird, indem eine Detektion des zurückgestreuten Messsignals (MS) erfolgt, wenn dessen Intensität einen vorgegebenen Schwellwert überschreitet.

8. Distanzmessverfahren nach einem der vorangehenden Ansprüche,
**dadurch gekennzeichnet, dass**
die Abtastrate einer Tabelle entnommen wird, in der Grobdistanzen geeignete Abtastraten zugeordnet werden, insbesondere wobei die Zuordnung von Grobdistanzen zu Abtastraten auf der Basis vorangegangener Distanzmeßvorgänge erfolgt.

9. Distanzmessverfahren nach einem der vorangehenden Ansprüche,
**dadurch gekennzeichnet, dass**
die Abtastrate solange verändert wird, bis die erste Ableitung an den Abtastpunkten des Zielsignals (Z) maximal ist.

10. Distanzmesser mit wenigstens

- einer Messsignalquelle (1) zum Aussenden wenigstens eines Messsignals (MS), insbesondere eines Lichtsignals, auf ein Zielobjekt (2,13), wobei wenigstens ein Startsignal (S) erzeugt wird, insbesondere durch Teilen des Messsignals (MS), wobei ein Teil des Messsignals (MS) über einen internen Referenzpfad geführt wird;
- einem Empfänger (3) zum Detektieren des vom Zielobjekt (2,13) zurückgestreuten Messsignals (MS) als Zielsignal (Z);
- einer Abtastschaltung zum Abtasten des empfangenen Zielsignals (Z) zur Bestimmung der relativen Lage von Startsignal (S) und Zielsignal (Z), wobei das Abtasten des Zielsignals (Z) an Abtastpunkten eines der Abtastrate zugeordneten Abtastrasters erfolgt;
- einer Steuer- und Auswertekomponente (9) zum Ableiten einer Distanz zum Zielobjekt (2,13) aus der relativen Lage von Startsignal (S) und Zielsignal (Z);

**dadurch gekennzeichnet dass**
die Abtastschaltung so ausgebildet ist, dass die Abtastrate verstellbar und in Abhängigkeit von einer Grobdistanz zum Zielobjekt einstellbar, insbesondere automatisch einstellbar ist.

11. Distanzmesser nach Anspruch 10,
**dadurch gekennzeichnet, dass**
die Abtastschaltung einen Frequenzgenerator (10) aufweist.

12. Distanzmesser nach Anspruch 11,
**dadurch gekennzeichnet, dass**
die Abtastschaltung einen Frequenzsynthesizer aufweist, insbesondere einen Direct Digital Synthesizer, Fractional-N Synthesizer oder einen spannungsgesteuerten und auf einer Phasenregelschleife-basierten Integer-N-Synthesizer.

13. Distanzmesser nach einem der Ansprüche 10 bis 12,
**gekennzeichnet durch**
eine laufzeitmessende Messschaltung zur Grobdistanzmessung, die so ausgebildet ist, dass eine Detektion des zurückgestreuten Messsignals (MS) erfolgt, wenn dessen Intensität einen vorgegebenen Schwellwert überschreitet.

14. Distanzmesser nach einem der Ansprüche 10 bis 13,

**gekennzeichnet durch**
eine Speichereinheit zum Speichern von Grobdistanzen für vorbekannte Zielobjekte.

**15.** Distanzmesser nach einem der Ansprüche 10 bis 14,
**gekennzeichnet durch**
eine Grobdistanz-Messsignalquelle und einen Grobdistanz-Empfänger, wobei diese so ausgebildet und angeordnet sind, dass sie einen von der Messsignalquelle und dem Empfänger unabhängigen zweiten Messpfad definieren.

## Claims

**1.** A distance measuring method, in particular according to the time-of-flight measuring method, comprising at least

- emitting at least one measurement signal (MS), in particular a light signal, to a target object (2, 13), wherein at least one start signal (S) is generated;
- receiving the measurement signal (MS) backscattered from the target object (2, 13) as a target signal (Z);
- sampling the received target signal (Z) with a sampling rate and determining the relative position of the start signal (S) and the target signal (Z), wherein the target signal (Z) is sampled at sampling points of a sampling pattern assigned to the sampling rate;
- deriving a distance to the target object (2, 13) from the relative position of the start signal (S) and the target signal (Z);

**characterized in that**
the sampling rate is adjustable and is set in a manner dependent on a coarse distance to the target object.

**2.** The distance measuring method as claimed in claim 1,
**characterized in that**
the sampling rate is set such that a respective position of the start signal (S) and the target signal (Z) relative to the sampling pattern is identical, such that the start and target signals are sampled at identical locations of the respective signal profile.

**3.** The distance measuring method as claimed in claim 1 or 2,
**characterized in that**
the sampling rate is set in accordance with one of the following relationships

$$f = \lfloor N \rfloor \cdot \frac{c}{2D} \quad \text{or} \quad f = \lceil N \rceil \cdot \frac{c}{2D}$$

wherein

*f* denotes the sampling rate to be set for sampling,
*c* denotes the speed of light,
*D* denotes the coarse distance,
*N* denotes the number of sampling intervals between the start signal and the target signal,
$\lfloor N \rfloor$ denotes the rounding-down function, and
$\lceil N \rceil$ denotes the rounding-up function for the number of sampling intervals between the start signal and the target signal.

**4.** The distance measuring method as claimed in any one of the preceding claims,
**characterized in that**
a synthetic distance error is determined for the target signal (Z), in particular by linear interpolation of a target signal (Z) shifted in terms of its position.

**5.** The distance measuring method as claimed in any one of the preceding claims,
**characterized in that**
the coarse distance to the target object (2, 13) is ascertained by means of a coarse distance measurement.

6. The distance measuring method as claimed in claim 5,
**characterized in that**
emitting, receiving and sampling are carried out for a first and a second measurement signal,
wherein a coarse distance is derived from the first measurement signal and the sampling rate for sampling the second measurement signal is set in a manner dependent on the coarse distance thus determined.

7. The distance measuring method as claimed in claim 5 or 6,
**characterized in that**
the coarse distance to the target object (2, 13) is ascertained in a manner dependent on the time of flight by virtue of the backscattered measurement signal (MS) being detected if the intensity thereof exceeds a predefined threshold value.

8. The distance measuring method as claimed in any one of the preceding claims,
**characterized in that**
the sampling rate is taken from a table in which suitable sampling rates are assigned to coarse distances, in particular wherein the assignment of coarse distances to sampling rates is effected on the basis of previous distance measuring processes.

9. The distance measuring method as claimed in any one of the preceding claims,
**characterized in that**
the sampling rate is varied until the first derivative at the sampling points of the target signal (Z) is maximal.

10. A distance measuring element comprising at least

- a measurement signal source (1) for emitting at least one measurement signal (MS), in particular a light signal, to a target object (2, 13), wherein at least one start signal (S) is generated, in particular by splitting the measurement signal (MS), wherein part of the measurement signal (MS) is passed via an internal reference path;
- a receiver (3) for detecting the measurement signal (MS) backscattered from the target object (2, 13) as a target signal (Z);
- a sampling circuit for sampling the received target signal (Z) for determining the relative position of the start signal (S) and the target signal (Z), wherein the target signal (Z) is sampled at sampling points of a sampling pattern assigned to the sampling rate;
- a control and evaluation component (9) for deriving a distance to the target object (2, 13) from the relative position of the start signal (S) and the target signal (Z);

**characterized in that**
the sampling circuit is designed such that the sampling rate is adjustable and is settable, in particular automatically settable, in a manner dependent on a coarse distance to the target object.

11. The distance measuring element as claimed in claim 10,
**characterized in that**
the sampling circuit has a frequency generator (10) .

12. The distance measuring element as claimed in claim 11,
**characterized in that**
the sampling circuit has a frequency synthesizer, in particular a direct digital synthesizer, fractional-N synthesizer or a voltage-controlled and phase-locked-loop-based integer-N synthesizer.

13. The distance measuring element as claimed in any one of claims 10 to 12,
**characterized by**
a time-of-flight-measuring measurement circuit for coarse distance measurement, which is designed such that the backscattered measurement signal (MS) is detected if the intensity thereof exceeds a predefined threshold value.

14. The distance measuring element as claimed in any one of claims 10 to 13,
**characterized by**
a storage unit for storing coarse distances for previously known target objects.

15. The distance measuring element as claimed in any one of claims 10 to 14,

**characterized by**
a coarse distance measurement signal source and a coarse distance receiver, wherein these are designed and arranged such that they define a second measurement path independent of the measurement signal source and the receiver.

**Revendications**

1. Procédé de mesure de distance, en particulier selon le procédé de mesure du temps de propagation, consistant au moins à

   - émettre au moins un signal de mesure (MS), en particulier un signal lumineux, vers un objet cible (2, 13), au moins un signal de départ (S) étant généré ;
   - recevoir le signal de mesure (MS) rétrodiffusé par l'objet cible (2, 13) en tant que signal cible (Z) ;
   - échantillonner le signal cible reçu (Z) à une fréquence d'échantillonnage et déterminer la position relative du signal de départ (S) et du signal cible (Z), le signal cible (Z) étant échantillonné à des points d'échantillonnage d'une trame d'échantillonnage associée à la fréquence d'échantillonnage ;
   - dériver une distance à l'objet cible (2, 13) de la position relative du signal de départ (S) et du signal cible (Z) ;

   **caractérisé en ce que**
   la fréquence d'échantillonnage est ajustable et est réglée en fonction d'une distance approximative à l'objet cible.

2. Procédé de mesure de distance selon la revendication 1,
   **caractérisé en ce que**
   la fréquence d'échantillonnage est réglée de sorte qu'une position respective du signal de départ (S) et du signal cible (Z) par rapport à la trame d'échantillonnage soit la même, de sorte que le signal de départ et le signal cible sont échantillonnés aux mêmes points du profil de signal respectif.

3. Procédé de mesure de distance selon la revendication 1 ou 2,
   **caractérisé en ce que**
   la fréquence d'échantillonnage est réglée selon l'une des relations suivantes

$$f = \lfloor N \rfloor \cdot \frac{c}{2D} \text{ ou } f = \lceil N \rceil \cdot \frac{c}{2D}$$

   où

   *f* désigne la fréquence d'échantillonnage à régler pour l'échantillonnage,
   *c* la vitesse de la lumière,
   *D* la distance approximative,
   *N* le nombre d'intervalles d'échantillonnage entre le signal de départ et le signal cible,
   $\lfloor N \rfloor$ la fonction d'arrondi à l'unité mineure et
   $\lceil N \rceil$ la fonction d'arrondi à l'unité supérieure pour le nombre d'intervalles d'échantillonnage entre le signal de départ et le signal cible.

4. Procédé de mesure de distance selon l'une des revendications précédentes,
   **caractérisé en ce**
   **qu'**une erreur de distance synthétique pour le signal cible (Z) est déterminée, en particulier par interpolation linéaire d'un signal cible (Z) déplacé dans sa position.

5. Procédé de mesure de distance selon l'une des revendications précédentes,
   **caractérisé en ce que**
   la distance approximative à l'objet cible (2, 13) est déterminée par une mesure de distance approximative.

6. Procédé de mesure de distance selon la revendication 5,
   **caractérisé en ce que**
   l'émission, la réception et l'échantillonnage sont effectués pour un premier et un second signal de mesure, une distance approximative étant dérivée du premier signal de mesure et la fréquence d'échantillonnage pour échantillonner le second signal de mesure étant réglée en fonction de la distance approximative ainsi déterminée.

7. Procédé de mesure de distance selon la revendication 5 ou 6,
**caractérisé en ce que**
la distance approximative à l'objet cible (2, 13) est déterminée en fonction du temps de propagation en effectuant une détection du signal de mesure rétrodiffusé (MS) lorsque son intensité dépasse une valeur seuil prédéfinie.

8. Procédé de mesure de distance selon l'une des revendications précédentes,
**caractérisé en ce que**
la fréquence d'échantillonnage est tirée d'une table dans laquelle des fréquences d'échantillonnage appropriées sont associées à des distances approximatives, l'association de distances approximatives à des fréquences d'échantillonnage s'effectuant en particulier sur la base d'opérations de mesure de distance précédentes.

9. Procédé de mesure de distance selon l'une des revendications précédentes,
**caractérisé en ce que**
la fréquence d'échantillonnage est modifiée jusqu'à ce que la première dérivée aux points d'échantillonnage du signal cible (Z) soit maximale.

10. Dispositif de mesure de distance, comportant au moins

- une source de signal de mesure (1) pour émettre au moins un signal de mesure (MS), en particulier un signal lumineux, vers un objet cible (2, 13), au moins un signal de départ (S) étant généré, en particulier en divisant le signal de mesure (MS), une partie du signal de mesure (MS) étant conduite par un trajet de référence interne ;
- un récepteur (3) pour détecter le signal de mesure (MS) rétrodiffusé par l'objet cible (2, 13) en tant que signal cible (Z) ;
- un circuit d'échantillonnage pour échantillonner le signal cible reçu (Z) pour déterminer la position relative du signal de départ (S) et du signal cible (Z), le signal cible (Z) étant échantillonné à des points d'échantillonnage d'une trame d'échantillonnage associée à la fréquence d'échantillonnage ;
- un composant de commande et d'évaluation (9) pour dériver une distance à l'objet cible (2, 13) de la position relative du signal de départ (S) et du signal cible (Z) ;

**caractérisé en ce que**
le circuit d'échantillonnage est conçu de sorte que la fréquence d'échantillonnage soit ajustable et réglable, en particulier réglable automatiquement, en fonction d'une distance approximative à l'objet cible.

11. Dispositif de mesure de distance selon la revendication 10,
**caractérisé en ce que**
le circuit d'échantillonnage présente un générateur de fréquence (10).

12. Dispositif de mesure de distance selon la revendication 11,
**caractérisé en ce que**
le circuit d'échantillonnage présente un synthétiseur de fréquence, en particulier un synthétiseur numérique direct, un synthétiseur à N fractionnaire ou un synthétiseur à N entier commandé en voltage et basé sur une boucle à verrouillage de phase.

13. Dispositif de mesure de distance selon l'une des revendications 10 à 12,
**caractérisé par**
un circuit de mesure du temps de propagation pour la mesure de distance approximative, qui est conçu de sorte que le signal de mesure (MS) rétrodiffusé soit détecté lorsque son intensité dépasse une valeur seuil prédéfinie.

14. Dispositif de mesure de distance selon l'une des revendications 10 à 13,
**caractérisé par**
une unité de mémoire pour mémoriser des distances approximatives pour des objets cibles déjà connus.

15. Dispositif de mesure de distance selon l'une des revendications 10 à 14,
**caractérisé par**
une source de signal de mesure de distance approximative et un récepteur de distance approximative, lesquels sont conçus et disposés de sorte qu'ils définissent un second trajet de mesure indépendant de la source de signal de mesure et du récepteur.

11
10
5
3
7
8
9
6
MS
12
2
4
1
Fig. 1
1
13
MS
3
Fig. 2
s(t)
S
Z
14
t
N
Fig. 3

s(t)
S
Z
t
14

Fig. 4

s(t)
S
Z
t
14'

Fig. 5

s(t)
Z
SW
t

Fig. 6

dB
2
0
-2
-4
-6
-8
-10
-12
0
50
100
150
200
250
MHz
AS
DS

Fig. 7a

dB
5
0
-5
-10
-15
-20
0
50
100
150
200
250
MHz
AS
DS

Fig. 7b

dB
0.5
0
-0.5
-1
-1.5
-2
-2.5
-3
-3.5
0
0.05
0.1
0.15
0.2
0.25
0.3
0.35
0.4
0.45
0.5
f
AS
DS

Fig. 8a

dB
1
0
-1
-2
-3
-4
-5
-6
-7
AS
DS
0
0.05
0.1
0.15
0.2
0.25
0.3
0.35
0.4
0.45
0.5
f

Fig. 8b

s(t)
1.2
1
0.8
0.6
0.4
0.2
0
-0.2
DS
AS
245
246
247
248
249
250
251
252
253
254
255
t

Fig. 9a

s(t)
1.2
1
0.8
0.6
0.4
0.2
0
-0.2
245 246 247 248 249 250 251 252 253 254 255
t
AS
DS

Fig. 9b

s(t)
1.2
1
0.8
0.6
0.4
0.2
0
-0.2
245 246 247 248 249 250 251 252 253 254 255
t
DS
AS

Fig. 9c

s(t)
1.2
1
0.8
0.6
0.4
0.2
0
-0.2
245
246
247
248
249
250
251
252
253
254
255
AS
DS
t

Fig. 10a

s(t)
1.2
1
0.8
0.6
0.4
0.2
0
-0.2
245
246
247
248
249
250
251
252
253
254
255
DS
AS
t

Fig. 10b

s(t)
1.2
1
0.8
0.6
0.4
0.2
0
-0.2
245
246
247
248
249
250
251
252
253
254
255
t
AS
DS

Fig. 10c

ΔD
1
0.9
0.8
0.7
0.6
0.5
0.4
0.3
0.2
0.1
0
0
0.2
0.4
0.6
0.8
1
1.2
1.4
1.6
1.8
2

Fig. 11a

ΔD
0.4
0.35
0.3
0.25
0.2
0.15
0.1
0.05
0
0
0.2
0.4
0.6
0.8
1
1.2
1.4
1.6
1.8
2

Fig. 11b

ΔD
ΔDS
ΔDZ - ΔDS
ΔDZ
0
1
ΔD
ΔDS* ΔDZ*
ΔDS
ΔDZ
0
1

Fig. 12a

Fig. 12b

ΔD
$\Delta D_{Z2}$
$\Delta D_S$
$\Delta D_{Z1}$
$\Delta D_Z$
0
1

Fig. 13

ΔD
$\Delta D_{Z3}$
$\Delta D_{Z2}$
$\Delta D_{Z1}$
$\Delta D_{Zn}$
0
1

Fig. 14

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2011076907 A
- WO 2008009387 A